**Europäisches Patentamt**

**European Patent Office**

**Office européen des brevets**

(11) Publication number: **0 204 679**
**B1**

# EUROPEAN PATENT SPECIFICATION

(45) Date of publication of patent specification: **16.08.90**

(51) Int. Cl.⁵: **H 05 K 7/20**

(21) Application number: **86850198.2**

(22) Date of filing: **05.06.86**

(54) A cooling arrangement.

(30) Priority: **06.06.85 SE 8502799**

(43) Date of publication of application:
**10.12.86 Bulletin 86/50**

(45) Publication of the grant of the patent:
**16.08.90 Bulletin 90/33**

(84) Designated Contracting States:
**AT BE CH DE FR GB IT LI LU NL SE**

(56) References cited:
**GB-A- 874 796**
**US-A-3 508 117**

**Ericsson Review, no 4, 1981, p. 188-195,
Almquist: "Kylsystem för elektroniska
telefonstationer"**

**IBM Technical Disclosure Bulletin, vol. 17 no 4,
September 1974, p. 1006, Connors: "Variable-
Area Heat Sink Device"**

(73) Proprietor: **Fläkt Aktiebolag
Sickla Allé 13
S-131 34 Nacka (SE)**

(72) Inventor: **Lanquist, Roland Edvin Robert
Lokes väg 15
S-148 00 Ösmo (SE)**
Inventor: **Hillerbrant, Bengt Harry
Blabarstigen 36
S-144 00 Rönninge (SE)**

(74) Representative: **Lindblom, Erik J.
Skördevägen 88
S-122 35 Enskede (SE)**

Courier Press, Leamington Spa, England.

## Description

### Technical field

The present invention relates primarily to a cooling arrangement for cooling an array of electronic equipment, for the purpose of improving the cooling effect of the used cooling element with the air of an air-flow, or air circulation as stated in the preamble of claim 1.

A prime object of the invention is to provide ways and means for enabling an air-flow cooled by a cooling element to sink down towards the array of electronic equipment, preferably between two arrays of equipment, while an air-flow, heated by said array or arrays during the operation of the electronic components embodied therein, is able to rise towards the cooling element.

This creates conditions by means of which the heated and cooled air-flows can rise and fall by natural convection, so as to cool the heat-generating electronic equipment.

By "forced convection" as used hereinafter is meant that a heated air-flow, which due to its lower density rises through natural convection, is assisted (forced) in its upward movement, or forced to move laterally, as a result of an ejector effect created by a further air-flow.

### Background prior art

Cooling elements of this kind and cooling systems which work in accordance with the principles of natural or gravitational convection are known to the art in many different forms.

For example, there is known to the art a warm-air cooling system for cooling electronic equipment, such as telecommunication equipment, in which the equipment to cooled is stacked in rows of equipment stands placed in side-by-side relationship with passageways therebetween, and in which system a cooling element is arranged above respective passageways.

This known system operates in accordance with natural convection principles, where an air-flow heated by the array or arrays of heat-generating electronic equipment rises and passes into the cooling element, where it is cooled and subsequently sinks down onto the floor and passes from there into the arrays of equipment, where it takes- up heat from the heat-generating components so as to form the aforesaid heated air-flow.

One such known system is retailed under the tradename "Ericool" by RIFA AB, Stockholm, Sweden, and is described in "Ericsson Review, No. 4, 1981, pages 188—195, Almquist" under the heading "Kylsystem" för electroniska telefonstationer".

Other systems for cooling arrays or racks of electrical equipment are also known to the art.

For example, systems are known in which the cooling elements can be placed immediately above an array of electronic equipment.

Systems have also been proposed in which one or more cooling elements are placed adjacent one or more component agglomerates, where a plurality of such agglomerates forms the aforesaid array. This system provides a cooling effect in the immediate vicinity of the heat-generating components, while at the same time affording the possibility of controlling the cooling effect to some extent in response to the heat generated.

So-called induction systems used for ventilating office premises also belong to the known state of the art. These systems include an injection nozzle with which return air is entrained from the premises by an ejector action, thereby affording good mixture of the ventilation air supplied to the apparatus through a duct system from a central air-treatment plant, where the ventilation air is preferably processed to a temperature of ±10°C in the air circulating in the premises.

### Summary of the present invention
### Technical problem

It is a known fact that the cooling capacity of existing cooling systems intended for the aforesaid purpose leaves much to be desired, and that consequently a qualified technical problem resides in the provision of conditions which enable such cooling systems to be made more efficient.

Another technical problem with known cooling systems of this kind is one of ensuring that cooled air will actually flow into and pass through the arrays or stacks of electronic equipment, so that the heat-generating electronic components embodied therein are truly cooled when in operation, since natural convection has not been found sufficiently effective in cooling the components to a satisfactory extent. Consequently, a related qualified technical problem is one of creating with the aid of simple means a forced and guided flow of both cool and warm air, so as to enable a large amount of cool air to be used for cooling the electronic components.

Another technical problem is one of enabling an existing cooling system to be modified with simple means requiring but little space, and of enabling the modifying steps taken to be concentrated solely to the cooling element (S), such that the modification can be carried out without requiring additional interference to the remaining, existing system components.

Another technical problem is one of creating with the aid of simple means conditions which enable the cooling effect of a cooling system to be adjusted efficiently to the prevailing load on the electronic components of the array or arrays of electronic equipment when the equipment is working, and to the heat generated by the electronic components at a given moment in time.

A further technical problem is one of creating conditions such that each electronic component incorporated in the electronic equipment is able to operate in an environment of relatively low ambient temperature, so as to extend the active working life of the equipment and its associated components and to reduce the influence of such factors as those which increase the error frequency.

A further technical problem is one of providing with the aid of simple means conditions which enable a cooling element according to the invention to be readily adapted for manufacture in accordance with known methods of manufacture for previously known cooling elements.

Another technical problem is one of providing a cooling element arrangement in which an extremely small forced air-flow is able to cause the entrainment of a warm air-flow in a manner to cause the warm air-flow to be guided into the cooling element and there be subjected to a greater cooling effect than would otherwise be usual solely under conditions of natural, or gravitational, convection.

Solution

The present invention thus relates to a cooling arrangement for cooling an array of electronic equipment by air circulation, as stated in the preamble of claim 1.

The present invention thus enables the cooling effect of the cooling element by the features mentioned in the characterizing part of claim 1.

Further embodiments within the scope of the invention are stated in the subclaims.

Advantages

The advantages primarily afforded by the arrangement according to the present invention reside in the provision of conditions which enable the cooling capacity of a cooling element to be increased, by creating a forced airstream which, through an ejector effect forces the air-flow heated by the array of electronic equipment to enter the cooling element. Nozzles and cooling elements are incorporated to form an assembly.

Brief description of the drawings

A preferred embodiment of an arrangement according to the invention will now be described in more detail with reference to the accompanying drawings, in which

Figure 1 illustrates in perspective and highly schematically a known cooling system used for cooling telecommunication equipment;

Figure 2 is a sectional view of a known cooling element, used in practice, which has been modified in accordance with the invention for use in a system of the kind illustrated in Figure 1;

Figure 3 is an end view of an alternative cooling system relative to Figure 1, used in conjunction with telecommunication equipment;

Figure 4 is a sectional view of a known cooling element used in practice, modified in accordance with the invention for use in a system of the kind illustrated in Figure 3;

Figure 5 illustrates in side view part of an array of electronic equipment and an arrangement for cooling electronic components which generate heat in operation;

Figure 6 is a perspective view of a perforated tube provided with means for forcibly guiding streams of air out through selected apertures; and

Figure 7 illustrates in perspective a device alternate to the device illustrated in Figure 6 and comprising two such guide means, which enable the number of exposed apertures and the exiting directions of the air-flows to be varied.

Description of a preferred embodiment

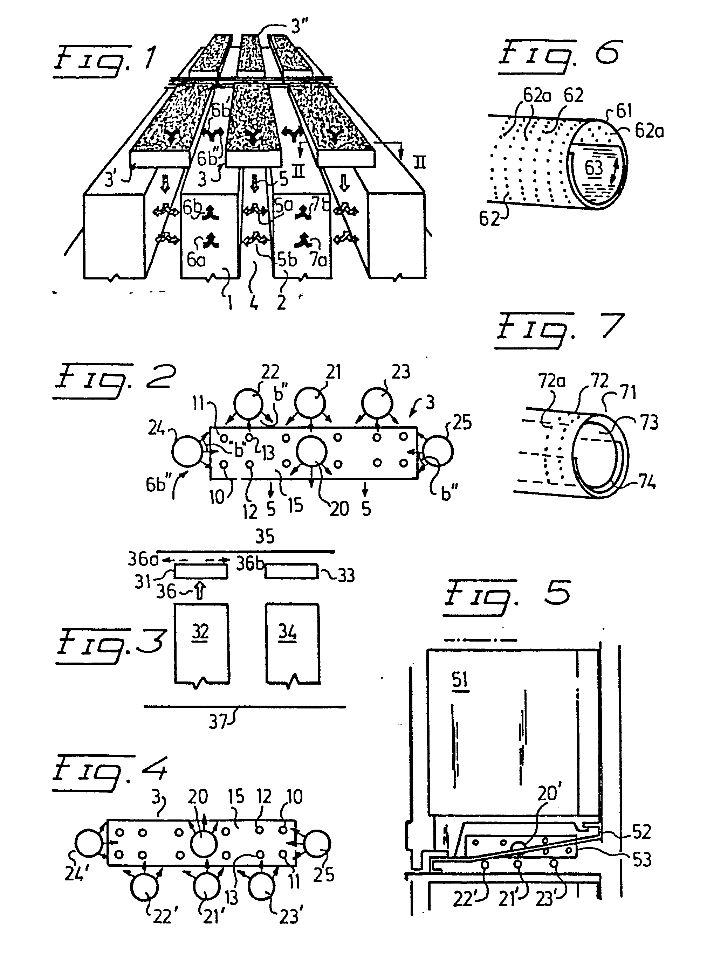

Figure 1 illustrates schematically and in perspective electronic telecommunication equipment which has been provided with a cooling system for cooling an array of electronic devices, such as electronic components and the like. The electronic equipment, mounted on printed circuit cards, is placed in frames which, in turn, are arranged in rows, such as the rows referenced 1 and 2 in Figure 1. Between mutually adjacent rows of frames, such as rows 1 and 2, there is provided passageway 4 (for maintenance personnel and the like), while a cooling element 3 is arranged above the passageway 4, adjacent the ceiling or roof structure.

The cooling element 3 is incorporated in a cooling system intended for cooling one or more arrays of electronic equipment 1 and 2 by gravitational convection, or natural convection, or by the circulation of air, the cooling element being placed above the arrays of electronic equipment, or preferably, as illustrated in Figure 1, between pairs of arrays 1 and 2.

With this arrangement a flow of air 5, 5a, 5b cooled by the cooling element 3 is able to sink down towards respective arrays of equipment, preferably between two mutually adjacent arrays, e.g. arrays 1 and 2, and onto the floor of the passageway 4. A stream of warm air 6a, 6b and 7a, 7b heated by the heat-generating electronic components in arrays 1 and 2 respectively is now able to rise up through the arrays of equipment in sweeping contact with the electronic components incorporated therein, while drawing cool air up through the arrays of equipment and towards the cooling element 3.

The present invention is based on the concept of increasing the cooling effect on the aforesaid warm air-flow, by introducing the flow into the cooling element as a forced air-flow, employing herefor an ejector effect or some like technique.

The present invention relates in particular to a novel cooling-element arrangement intended as a substitute for the cooling elements 3, 3' illustrated in Figure 1. Accordingly, a cooling element constructed in accordance with the invention is illustrated in Figure 2, which is a cross-sectional view taken on the line II—II in Figure 1.

The cooling element 3 illustrated in Figure 2 is coupled in a known manner, either in series or in parallel, with a coolant piping system, of which certain pipes have been referenced, 10, 11, 12 and 13, in the drawing.

The piping system incorporating the cooling element coacts with a number of closely packed cooling fins which extend along the piping system. Only one such fin has been shown in Figure 2, namely the fin 15.

The pipes of the cooling system can be connected together in series and/or in parallel.

Thus, with the known cooling system, the warm air-flow 6b is not able to pass the cooling fins 15 to a full extent, and be converted thereby to a cooled air-flow 5, which sinks down between the arrays of equipment, this upward flow of warm air into the regions of the cooling fins being achieved through convection forces.

In order to overcome this drawback, the cooling element of the present invention comprises a tube or duct, or a number of tubes or ducts, of which one is shown in the centre of the cooling element 3 in Figure 2 and referenced 20. It will be understood, however, that the cooling element can incorporate a number of such tubes, which are arranged to pass through the cooling fins 15. In certain instances it may be expedient to provide a tube, similar to the tube 20, between the four pipes forming part of the coolant piping system.

It is also possible, within the scope of the invention, to arrange one or more tubes adjacent the upper long side of the cooling element 3, this embodiment being particularly suited to the cooling system illustrated in Figure 1. An example of this particular arrangement of tubes is illustrated in Figure 2, with the tubes 21, 22 and 23 arranged above the cooling element 3. The devices by means of which the tubes are held or suspended have not been shown.

It will be noted that the tubes 21, 22, 23 can be installed above the cooling element without needing to interfere with the cooling elements of an existing cooling system.

It also lies within the scope of this invention to place one or more tubes 24, 25 on respective short sides of the cooling element 3. This modification can also be made to existing, previously installed cooling systems without needing to interfere with the systems.

In accordance with the invention the at least one tube 20 placed in the cooling element 3 and, when applicable, the tubes placed above the cooling element, is, or are, perforated with a plurality of apertures via which forced streams of air can be generated through the cooling element. These apertures, and therewith the air streams exiting therefrom, are preferably directed downwardly within an angle of 80° to the vertical plane. This angle is referenced "a" in Figure 2 with respect to the tube 22. The same conditions apply to the remaining tubes.

In those cases where the apertures are directed more horizontally, and provided, for example, in the tubes 24, 25 adjacent the short sides of the cooling element 3, it is suggested in accordance with the invention that the apertures are directed at an angle "b" smaller than 45° above the horizontal plane, and an angle "b'" equal to or smaller than 90° beneath the horizontal plane. The extremities of these angular values primarily apply when the tube 24 is placed between the illustrated four pipes 10, 11, 12 and 13.

As illustrated in Figure 2, the tube or duct 20, and the remaining tubes or ducts, extend parallel with the coolant pipes 10, 11, 12 and 13 of the piping system serving the cooling element 3, and are arranged to extend through, or closely adjacent to, the cooling fins of the cooling element.

In those cases where the tube 20 extends through all the cooling fins of the cooling element 3, it is proposed that each cooling fin is assigned mutually adjacent holes, said tube extending through said fins.

As before mentioned each of the forced air-flows, or air-streams, is intended to cause the warm air-flow 6b and 7b to pass into the cooling element through the ejector action generated, and therewith to increase the velocity of thhe air-flows while creating some degree of turbulence, so as to enhance the cooling effect of the cooling element 3 on the arm air-flows 6b and 7b.

Figure 1 illustrates how a flow of warm air 6b rising from an array of electronic equipment is forcibly guided, through the agency of an ejector effect, into a respective cooling element 3 and 3' located on a respective side of the array of electronic equipment. As will be readily understood, the air-flow 6b is divided into two part air-flows 6b' and 6b'', of which the former, 6b' is adapted to the cooling element 3 and the latter, 6b'', is adapted to the cooling element 3'.

In accordance with one advantageous embodiment, the tube 20, or the remaining tubes, is, or are, made slightly longer than the cooling element 3, and is, or are, provided with connecting portions for enabling the tube 20 associated with the cooling element 3 to be joined to a corresponding tube associated with the cooling element 3''.

Naturally, as an alternative, the tube 20 located in the cooling element 3 may be connected to a corresponding tube in the cooling element 3' with the aid of other connecting means, such as pipes, hoses and the like. In this respect, the tubes may be connected together in series and/or in parallel, with the aid of end-connectors and/or connections arranged in accordance with the orientation of the tube within the cooling element, by passing the connection between the cooling fins.

The forced air-flow generated in the tube, or tubes, is effected with the aid of a fan, or like forced air-flow generator, connected to the tube 20 or the remaining tubes 21, 22, 23, 24 and/or 25, said fan being adjusted to impart to the forced air-flow an overpressure beneath 2000 Pa, preferably an overpressure within the range 50—500 Pa.

The diameter of respective tubes 20, 21, 22, 23, 24 and 25 is suitably less than 75%, but greater than 25%, of the vertical extension (thickness) of the cooling element, preferably 50%.

Although the number of apertures provided in each tube may vary, it is proposed that the apertures are placed at locations between mutually adjacent cooling fins. Naturally, more than one aperture may be located between two fins.

Figure 3 is an end view of a cooling system intended as an alternative to the system illustrated in Figure 1 and used in conjunction with telecommunication equipment.

In this embodiment a cooling element 31 is located immediately above a row of electronic equipment 32, and a further cooling element is located immediately above a further row of equipment 34. The cooling elements 31 and 33 are located a short distance beneath a ceiling structure 35. It can be assumed that an air-flow 36 heated by the array of equipment 32 passes through the cooling element 31 and divides into two cooled part-flows 36a and 36b beneath the ceiling structure 35, these part-flows sinking down on either side of the array 32, towards the floor 37, and thereafter pass into the array of equipment 32 and there cool the electronic components and like devices incorporated therein.

Figure 4 illustrates a cooling element according to the invention provided with tubes or ducts 20', 21', 22', 23', 24' and 25', similar to the embodiment of Figure 2.

The previous description made with reference to Figure 2 also applies to the cooling element of Figure 4, but with the difference that the tubes or ducts 21', 22' and 23' are placed beneath the cooling element 3, and consequently the aforedescribed upwardly and downwardly flowing air streams will be reversed in this case.

As with the earlier described embodiment, the heated air-flow 36 entrained by the ejector effect created by the forced air stream forms an accelerated air-flow through the cooling element.

Figure 5 illustrates an alternative embodiment in which a cooling element 53 of principally the same kind as the cooling elements of Figures 2 and 4 is incorporated in an array of electronic equipment and placed beneath, or also above, such components or collection of devices as those which are expected to generate large quantities of heat.

It is assumed here that the aforesaid highly heat-generating components or devices are mounted on a printed circuit board 51 and that the cooling element 53 is positioned beneath a circuit-board holder or support 52.

In this case, it is possible to adjust the cooling effect of the cooling element, partly in response to the heat developed at any given moment in time, and partly in dependence on a developed maximum power, by increasing or decreasing the number of tubes or ducts 20', 21', 22' and 23' and by adjusting their positions and changing the direction of forcibly guided air-flows.

If the space available is not sufficient to accommodate the tubes 21', 22' and 23' located externally of the cooling element, these tubes may be dispensed with and a plurality of tubes, similar to the tube 20', may be extended through the cooling element instead.

Figure 6 illustrates in pespective a perforated tube or duct 61, having apertures 62 distributed uniformly around the periphery thereof. The tube 61 is provided internally with guide means in the form of a curved guide plate 63 for directing the forced air-flows through selected holes 62a. In this case the centre angle of selected apertures is determined by the angle of arc of the curved plate 63.

Figure 7 illustrates in perspective an alternative embodiment in the form of a perforated tube or duct 71 having apertures 72 distributed uniformly around the peripheral wall of the tube. This tube is provided internally with two curved guide plates 73 and 74 which can direct the forced air-flows out through holes 72a, and which plates can be displaced relative to one another in order to adjust the centre angle of arc.

Adjustments to the cooling effect afforded by the cooling element are made in dependence on the rate of the air-flow and on the prevailing temperature gradient.

The guide plates may be placed inside and/or on the tube and may extend only a short distance therefrom.

Conveniently, one or more of the tubes 20—25 may be fitted with the guide means of Figure 6 or the guide means of Figure 7, so that the cooling capacity of one and the same cooling element can be modified, depending upon its location in the system and on the cooling effect desired.

As beforementioned, although the guide means are shown to be inside the tube, they may also be placed on the outer wall surface thereof.

## Claims

1. A cooling arrangement for cooling an array of electronic equipment with the aid of air circulation, one cooling element having a coolant piping system, and being placed above the array of electronic equipment (1, 2) such that an air-flow (5, 5a, 5b) cooled by the cooling element (3) is able to sink down towards and around said array, preferably between two mutually adjacent arrays of equipment (1, 2) and such that an air-flow (6a, 6b and 7a, 7b) heated by the array or arrays of equipment (1, 2) is able to rise upwardly, characterized in that the cooling element (3) has one or more tubes (20—25) incorporated therein and/or has one or more tubes arranged in the close vicinity thereof; in that one end of the tube (20), or tubes, is connected to a forced air-flow generator; and in that said tube, or tubes, is, or are, provided with apertures along the peripheral wall surfaces thereof, to create conditions for a forced flow of air through the cooling element (3) by ejection.

2. An arrangement according to Claim 1, characterized in that the apertures are directed downwards and/or upwards, within an angle of 80° to the vertical plane.

3. An arrangement according to Claim 1 or 2, characterized in that the apertures are directed within an angle of less than 45° above and/or beneath the horizontal plane and equal to or less than 90° above and/or beneath a horizontal plane.

4. An arrangement according to Claim 1, characterized in that the tube (20) extends parallel with the pipes (10—13) incorporated in a coolant piping system associated with the cooling element (3) and passes through cooling fins (15) associated with said cooling element.

5. An arrangement according to Claim 4, characterized in that the cooling fins (15) are assigned mutually adjacent holes and in that the tube (20) extends through said fins.

6. An arrangement according to Claim 1, characterized in that the forced air-flow is directed for causing an ejector effect, such as to entrain a warm air-flow (6b, 7b) into the cooling element (3).

7. An arrangement according to Claim 1, characterized in that a warm air-flow (6b) departing from an array of electronic equipment (1, 2) is divided into part-flows, (6b', 6b'') each of which is entrained by an ejector effect into a cooling element (3, 3') placed on a respective side of the array (1, 2) of electronic equipment.

8. An arrangement according to Claim 1, characterized in that the forced air-flow, effective in creating an ejector effect for the entrainment of an air-flow (6b), has an over-pressure beneath 2000 Pa, preferably between 50 and 500 Pa.

9. An arrangement according to Claim 1, characterized in that a warm air-flow (6b) is arranged to pass into a cooling element (3) located directly in the cold air-flow in the cooling element (3).

10. An arrangement according to Claim 9, characterized in that a forced air-flow (24) generated for the purpose of entraining a warm air-flow (6b) by ejector action, is arranged between cooling element (3, 3') and above one array (1) of electronic equipment.

11. An arrangement according to Claim 1, characterized in that the tube (71) is provided with a plurality of apertures (72) in the wall thereof; and in that means (73) are provided for directing the air-flow through selected apertures.

12. An arrangement according to Claim 11, characterized in that the tube (71) is a perforated tube and has a plate (63) inserted therein or placed thereon.

13. An arrangement according to Claim 11, characterized in that the tube (61) is a perforated tube having two or more plates (73, 74) inserted therein or placed thereon for directing the air-flows through selected apertures (72a).

**Patentansprüche**

1. Kühlanordnung zur Kühlung einer elektronischen Ausrüstungsgruppe mittels Luftumwälzung, wobei ein Kühlelement ein Kühlmittelrohrleitungssystem aufweist und einerseits so oberhalb der elektronischen Ausrüstungsgruppe (1, 2) plaziert ist, daß ein vom Kühlelement (3) gekühlter Luftstrom (5, 5a, 5b) nach unten hin zu und um jene Gruppe herum sinken kann, vorzugsweise zwischen zwei zueinander benachbarte Ausrüstungsgruppen (1, 2) und andererseits so, daß ein von der Ausrüstungsgruppe oder -gruppen (1, 2) aufgeheizter Luftstrom (6a, 6b und 7a, 7b) nach oben steigen kann, dadurch gekennzeichnet, daß das Kühlelement (3) ein oder mehrere Rohre (20—25) eingebaut enthält und/oder ein oder mehrere Rohre in seiner nächsten Nähe angeordnet sind, daß ein Ende des Rohrs (20) oder der Rohre an einen Druckluftgenerator angeschlossen ist und daß jenes Rohr oder jene Rohre entlang seiner bzw. ihrer Umfangswandflächen Öffnungen aufweist bzw. aufweisen, um durch Ausstoß Bedingungen für einen Druckluftstrom durch das Kühlelement (3) zu schaffen.

2. Anordnung nach Anspruch 1, dadurch gekennzeichnet, daß die Öffnungen in einem Winkel von 80° zur Senkrechten nach unten und/oder oben ausgerichtet sind.

3. Anordnung nach Anspruch 1 oder 2, dadurch gekennzeichnet, daß die Öffnungen in einem Winkel von weniger als 45° oberhalb und/oder unterhalb der Waagrechten und in einem Winkel von 90° oder weniger oberhalb und/oder unterhalb einer Waagrechten ausgerichtet sind.

4. Anordnung nach Anspruch 1, dadurch gekennzeichnet, daß sich das Rohr (20) parallel zu den in einem Kühlmittelrohrleitungssystem, das dem Kühlelement (3) zugeordnet ist, eingebauten Rohrleitungen (10—13) erstreckt und durch jenem Kühlelement zugeordnete Kühlrippen (15) verläuft.

5. Anordnung nach Anspruch 4, dadurch gekennzeichnet, daß den Kühlrippen (15) zueinander benachbarte Löcher zugeordnet sind und daß sich das Rohr (20) durch jene Rippen erstreckt.

6. Anordnung nach Anspruch 1, dadurch gekennzeichnet, daß der Druckluftstrom so ausgerichtet ist, daß er eine solche Ausstoßwirkung hervorruft, daß ein warmer Luftstrom (6b, 7b) in das Kühlelement (3) eingetragen wird.

7. Anordnung nach Anspruch 1, dadurch gekennzeichnet, daß ein eine elektronische Ausrüstungsgruppe (1, 2) verlassender warmer Luftstrom (6b) in Teilströme (6b', 6b'') aufgeteilt wird, von denen jeder durch eine Ausstoßwirkung in ein Kühlelement (3, 3') eingetragen wird, das auf einer jeweiligen Seite der elektronischen Ausrüstungsgruppe (1, 2) plaziert ist.

8. Anordnung nach Anspruch 1, dadurch gekennzeichnet, daß der Druckluftstrom, der eine Ausstoßwirkung zum Eintrag eines Luftstromes (6b) verursacht, unter einem Überdruck von unter 2000 Pa, vorzugsweise zwischen 50 und 500 Pa, steht.

9. Anordnung nach Anspruch 1, dadurch gekennzeichnet, daß ein warmer Luftstrom (6b) in eine Kühlelement (3) hineinführt, das sich direkt im kalten Luftstrom befindet.

10. Anordnung nach Anspruch 9, dadurch gekennzeichnet, daß ein Druckluftstrom (24), der zum Eintrag eines warmen Luftstroms (6b) durch Ausstoßwirkung erzeugt wird, zwischen Kühlelement (3, 3') und einer obigen elektronischen Ausrüstungsgruppe (1) vorgesehen ist.

11. Anordnung nach Anspruch 1, dadurch gekennzeichnet, daß in der Wand des Rohrs (71) eine Mehrzahl von Öffnungen (72) vorgesehen sind und daß Mittel (73) vorgesehen sind, um den Luftstrom durch ausgewählte Öffnungen zu richten.

12. Anordnung nach Anspruch 11, dadurch gekennzeichnet, daß es sich bei dem Rohr (71) um ein perforiertes Rohr handelt, das eine darin eingeführte oder darauf aufgelegte Platte (63) aufweist.

13. Anordnung nach Anspruch 11, dadurch gekennzeichnet, daß es sich bei dem Rohr (61) um ein perforiertes Rohr handelt, das zwei oder mehr darin eingeführte oder darauf aufgelegte Platten (73, 74) aufweist, um die Luftströme durch ausgewählte Öffnungen (72a) zu richten.

**Revendications**

1. Agencement de refroidissement pour refroidir un ensemble d'équipement électronique à l'aide d'une circulation d'air, un élément de refroidissement ayant un réseau de canalisations d'agent de refroidissement et étant placé au-dessus de l'ensemble d'équipement électronique (1, 2) de telle façon qu'un courant d'air (5, 5a, 5b) refroidi par l'élément de refroidissement (3) puisse descendre en direction et autour dudit ensemble, de préférence entre deux ensembles d'équipement (1, 2) adjacents, et de telle façon qu'un courant d'air (6a, 6b et 7a, 7b) chauffé par l'ensemble ou les ensembles d'équipement (1, 2) puisse monter vers le haut, caractérisé en ce que l'élément de refroidissement (3) comporte un ou plusieurs tube(s) (20—25) logé(s) dans son intérieur et/ou comporte un ou plusieurs tube(s) disposé(s) à sa proximité immédiate; en ce qu'une extrémité du tube (20), ou des tubes, est raccordée à un générateur de courant d'air forcé; et en ce que le(s) dit(s) tube(s), est (sont) pourvu(s) d'ouvertures le long des surfaces périphériques de leur paroi, pour créer les conditions d'un courant d'air forcé à travers l'élément de refroidissement (3) par éjection.

2. Agencement suivant la revendication 1, caractérisé en ce que les ouvertures sont dirigées vers le bas et/ou vers le haut, à l'intérieur d'un angle de 80° par rapport au plan vertical.

3. Agencement suivant la revendication 1 ou 2, caractérisé en ce que les ouvertures sont dirigées à l'intérieur d'un angle de moins de 45° au-dessus et/ou en dessous du plan horizontal et égal ou inférieur à 90° au-dessus et/ou en dessous d'un plan horizontal.

4. Agencement suivant la revendication 1, caractérisé en ce que le tube (20) s'étend parallèlement aux tubes (10—13) incorporés dans un réseau de canalisations d'agent de refroidissement associé à l'élément de refroidissement (3) et passe à travers des ailettes de refroidissement (15) associées audit élément de refroidissement.

5. Agencement suivant la revendication 4, caractérisé en ce que les ailettes de refroidissement (15) sont dotées de trous mutuellement adjacents et en ce que le tube (20) s'étend à travers lesdites ailettes.

6. Agencement suivant la revendication 1, caractérisé en ce que le courant d'air forcé est orienté de façon à provoquer un effet d'éjection, afin d'entraîner un courant d'air chaud (6b, 7b) à l'intérieur de l'élément de refroidissement (3).

7. Agencement suivant la revendication 1, caractérisé en ce qu'un courant d'air chaud (6b) partant d'un ensemble d'équipement électronique (1, 2) est divisé en des courants partiels (6b', 6b''), dont chacun est entraîné par un effet d'éjection à l'intérieur d'un élément de refroidissement (3, 3') placé sur un côté respectif de l'ensemble (1, 2) d'équipement électronique.

8. Agencement suivant la revendication 1, caractérisé en ce que le courant d'air forcé, servant à créer un effet d'éjection pour entraîner un courant d'air (6b), présente une surpression inférieure à 2000 Pa, de préférence entre 50 et 500 Pa.

9. Agencement suivant la revendication 1, caractérisé en ce qu'un courant d'air chaud (6b) est agencé de façon à passer à l'intérieur d'un élément et refroidissement (3) situé directement dans le courant d'air froid dans l'élément de refroidissement (3).

10. Agencement suivant la revendication 9, caractérisé en ce qu'un courant d'air forcé (24), créé dans le but d'entraîner un courant d'air chaud (6b) par un effet d'éjection, est disposé entre des éléments de refroidissement (3, 3') et au-dessus d'un ensemble (1) d'équipement électronique.

11. Agencement suivant la revendication 1, caractérisé en ce que le tube (71) est pourvu d'une pluralité d'ouvertures (72) dans sa paroi; et en ce qu'il est prévu des moyens pour diriger le courant d'air à travers des ouvertures sélectionnées.

12. Agencement suivant la revendication 11, caractérisé en ce que le tube (61) est un tube perforé et comporte une plaque (63) insérée à l'intérieur ou placée par dessus.

13. Agencement suivant la revendication 11, caractérisé en ce que le tube (71) est un tube perforé comportant deux ou plus de deux plaques (73, 74) insérées à l'intérieur ou placées par dessus pour diriger les courants d'air à travers des ouvertures sélectionnées (72a).

Fig. 1

Fig. 2

Fig. 3

Fig. 4

Fig. 5

Fig. 6

Fig. 7